# EUROPEAN PATENT APPLICATION

(11) **EP 4 131 636 A1**
(43) Date of publication of application: **08.02.2023**
(21) Application number: 21776921.5
(22) Date of filing: 12.02.2021
(51) Int. Cl.: H01P 1/00, H01L 25/00, G01R 29/08, H04B 1/38

(54) **RF DETECTOR AND HIGH-FREQUENCY MODULE COMPRISING SAME**

(30) Priority: 26.03.2020 JP 2020056667
(71) Applicant: YOKOWO CO., LTD., Kita-ku Tokyo 114-8515 (JP)
(72) Inventor: MITSUGI Kenichi, Tomioka-Shi, Gunma 370-2495 (JP); ICHIHARA Takeshi, Tomioka-Shi, Gunma 370-2495 (JP)
(74) Representative: Gunzelmann, Rainer
(86) International application number: PCT/JP2021/005233
(87) International publication number: WO 2021/192707

(57) **Abstract**

An RF detector or a high-frequency module including the RF detector is configured to have sufficient mechanical characteristics while maintaining satisfactory conversion characteristics even at a frequency in a quasi-millimeter-wave band or higher. For example, an RF detector 1 including: a detection element 20 that detects a signal strength of an RF signal; and a printed circuit board 10 on which a first conductive pattern in electrical continuity with an input end of the detection element 20 and a second conductive pattern in electrical continuity with an output end of the detection element 20 are formed is configured. In the RF detector 1, the first conductive pattern and the second conductive pattern face each other across the detection element 20, and capacitive coupling is achieved between the conductive patterns as a result.

## Description

### Technical Field

The present invention relates to an RF detector and a high-frequency module including the RF detector.

### Background Art

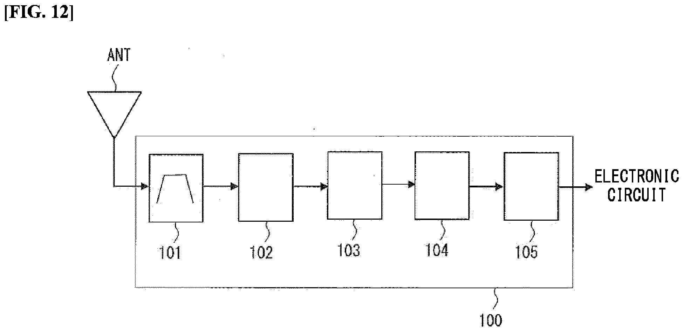

A general configuration example of a high-frequency module having a radio frequency detector (RF detector) is illustrated in Figure 12. A high-frequency module 100 in Figure 12 inputs an RF signal obtained by attenuating, by an RF filter 101, an out-of-band component out of a signal received by an antenna ANT to an RF detector 102. The RF detector 102 converts the input RF signal to a DC voltage corresponding to the signal strength (power) thereof. The converted RF signal (DC voltage) is amplified by an amplifier 103 and is then subjected to analog-to-digital conversion by an A/D converter 104. A digital signal processor (DSP) 105 outputs the digitally converted RF signal to an electronic circuit in a subsequent stage as digital data indicating the signal strength thereof.

The RF detector 102 is a high-frequency component including a detection element such as a rectifier diode as a main component, and RF detectors disclosed in Patent Literatures 1 and 2 have hitherto been known, for example.

The RF detector disclosed in Patent Literature 1 is used in a microwave band and eliminates the characteristic variation of a rectifier diode by adding an impedance adjustment element. As the rectifier diode, a silicon Schottky barrier diode is mainly used.

The RF detector disclosed in Patent Literature 2 includes a rectifier circuit that rectifies an RF signal in a 24 GHz band. Therefore, the RF detector disclosed in Patent Literature 2 can suppress the decrease of conversion characteristics when the operation frequency band is high. In the rectifier circuit, two rectifier diodes are connected to each other in parallel between an output unit and the ground (ground surface). A plurality of fan-shaped open stubs (resonators) are included in the output unit. As a result, highly-efficient electric power conversion across a broad band becomes possible.

### Citation List

### Patent Literature

Patent Literature 1: Japanese Patent Laid-Open No. 2001-86666
Patent Literature 2: Japanese Patent Laid-Open No. 2014-209816

### Summary of Invention

### Technical Problem

In recent years, a 5th generation mobile communication system (5G) has been proposed as one of next-generation communication standards. In 5G, the use of apparatuses and systems in a 26 GHz band and a 28 GHz band that are quasi-millimeter-wave bands or frequency bands higher than those bands is planned. Therefore, in future, an RF detector that enables usage in a high-frequency band higher than a quasi-millimeter-wave band in examination of an electric wave environment, product inspection, the operation check of products and components, and the like for 5G becomes essential.

The quasi-millimeter-wave band to be used in 5G is from 24.25 GHz to 27.5 GHz in a 26 GHz band. The quasi-millimeter-wave band to be used in 5G is from 26.5 GHz to 29.5 GHz in a 28 GHz band.

Patent Literatures 1 and 2 are silent as to the material of the printed circuit board on which the high-frequency components are mounted. However, for high-frequency components from 1 GHz to 10 GHz, an inexpensive flame-retardant-4 (FR-4) grade printed circuit board ("FR-4 board") based on glass fiber is generally used. In the printed circuit board, the transmission speed of the signal becomes higher as a permittivity ε becomes lower, and the transmission loss becomes greater as the operation frequency band becomes higher. Therefore, as the printed circuit board used in the quasi-millimeter-wave band, a high-frequency board in which low-loss fluororesin serves as an insulator, for example, has hitherto been used instead of the FR-4 board based on glass fiber with high loss and high permittivity ε.

However, the high-frequency board is not only much more expensive than the FR-4 board, but also falls behind the FR-4 board in terms of workability and productivity. The thickness of the board (printed circuit board) is preferred to be thicker when mechanical characteristics (strength and tolerance) are taken into consideration. However, when the board becomes thicker, the line width of a signal line in electrical continuity with an electronic circuit in a subsequent stage becomes thicker. When the line width becomes thicker, the matching becomes even more difficult, and satisfactory conversion characteristics cannot be obtained. By employing a multilayer structure, it is possible to make each substrate thinner to thereby reduce loss and improve conversion characteristics. However, a multilayer structure increases manufacturing costs.

Furthermore, silicon Schottky barrier diodes that have been used as rectifier diodes have a low potential difference in the forward direction. Therefore, relatively high conversion characteristics can be obtained in an up to 10 GHz band, but the conversion characteristics rapidly decrease in high-frequency bands higher than the 10 GHz band. If matching is forcibly achieved in a broad band with the silicon Schottky barrier diode, the conversion characteristics are sacrificed. Mass production is difficult with an individual response of individually improving the characteristic variations of the rectifier diode.

For example, as in the RF detector disclosed in Patent Literature 2, in a configuration in which the rectifier diodes are connected to each other in parallel, sufficient current capacity can be ensured, but matching is difficult due to the influence of the capacity between the output unit and the ground, and sufficient conversion characteristics cannot be obtained when there is mismatching. As the rectifier diode used in the 24 GHz band, a GaAs (gallium arsenide) diode, a planar-doped barrier diode, and the like that are dozens of times more expensive than a silicon Schottky barrier diode, have a fast electron mobility, and can respond to high frequencies are used.

Therefore, the cost reduction and mass production of the RF detector that can be used in a quasi-millimeter-wave band or higher or the high-frequency module including such an RF detector have been difficult.

One object of the present invention is to cause an RF detector or a high-frequency module including the RF detector to have a structure having sufficient mechanical characteristics while maintaining satisfactory conversion characteristics even at a frequency in a quasi-millimeter-wave band or higher. Other objects of the present invention will be clear from the description herein.

### Solution to Problem

One aspect of the present invention is an RF detector including: a detection element that detects a signal strength of an RF signal; and a printed circuit board on which a first conductive pattern in electrical continuity with an input end of the detection element and a second conductive pattern in electrical continuity with an output end of the detection element are formed. In the RF detector, the first conductive pattern and the second conductive pattern face each other across the detection element, and capacitive coupling is achieved between the conductive patterns.

Another aspect of the present invention is a high-frequency module including an RF detector that exists on a front surface of a printed circuit board with a rear surface serving as a ground conductor, the RF detector detecting a signal level of an input RF signal. In the high-frequency module, the RF detector is the RF detector of the abovementioned aspect.

### Advantageous Effects of Invention

According to each of the abovementioned aspects, the width of the operation frequency band can be enlarged without causing matching between the detection element and each of the first conductive pattern and the second conductive pattern. Therefore, satisfactory conversion characteristics can be maintained even when the detection element and the printed circuit board used in a microwave band are used in a quasi-millimeter-wave band or higher. Therefore, an RF detector and a high-frequency module that have sufficient mechanical characteristics and are also capable of reducing cost can be easily realized.

### Brief Description of Drawings

[Figure 1]

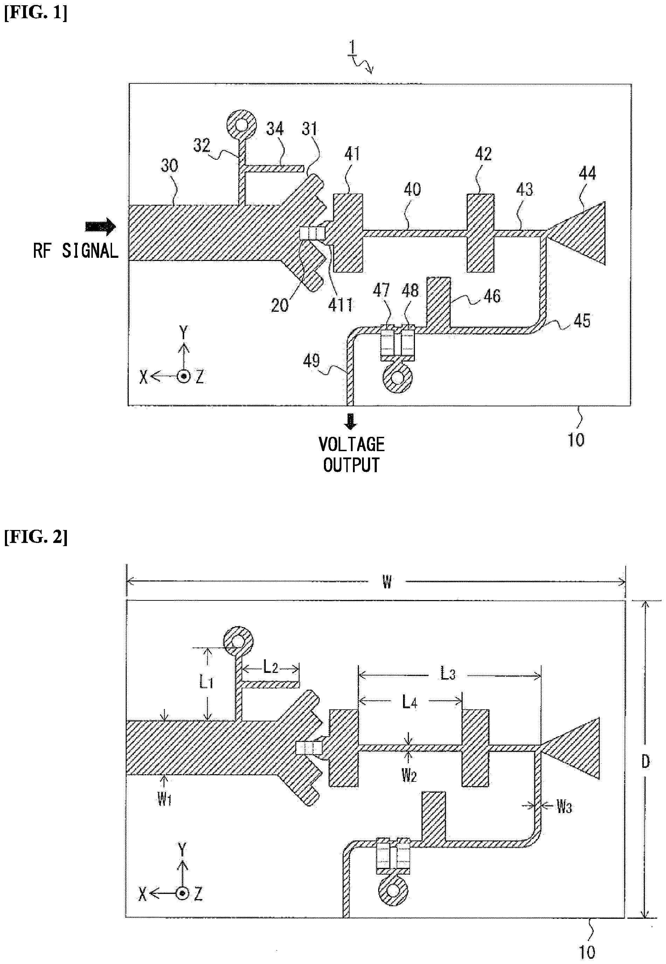

   Figure 1 is a configuration diagram of an RF detector according to a first embodiment.
[Figure 2]
   Figure 2 is an explanatory diagram of the size and the arrangement interval of the RF detector according to the first embodiment.
[Figure 3]

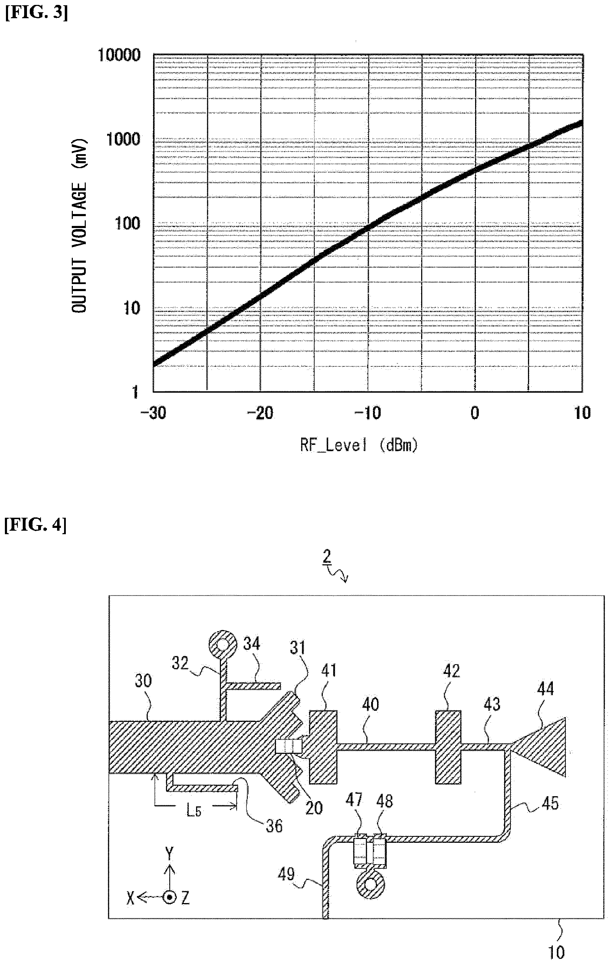

   Figure 3 is a conversion characteristic diagram of the RF detector of the first embodiment.
[Figure 4]
   Figure 4 is a configuration diagram of an RF detector according to a second embodiment.
[Figure 5]

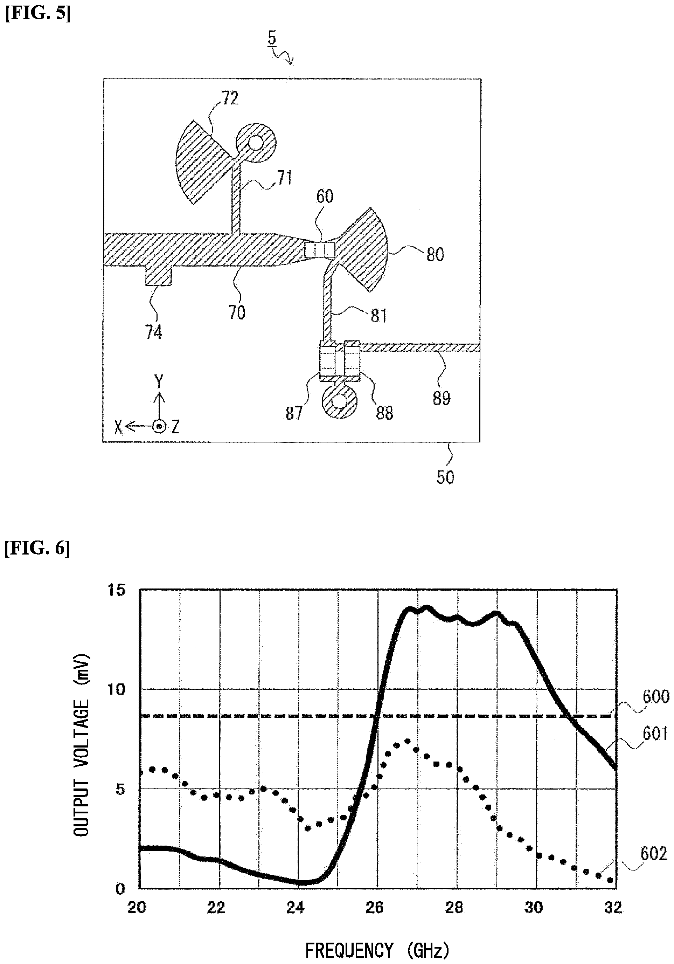

   Figure 5 is a configuration diagram of an RF detector according to a comparative example.
[Figure 6]
   Figure 6 is an output voltage (mV)-frequency (GHz) characteristic comparison diagram in accordance with the RF detector according to the second embodiment and the RF detector according to the comparative example.
[Figure 7]

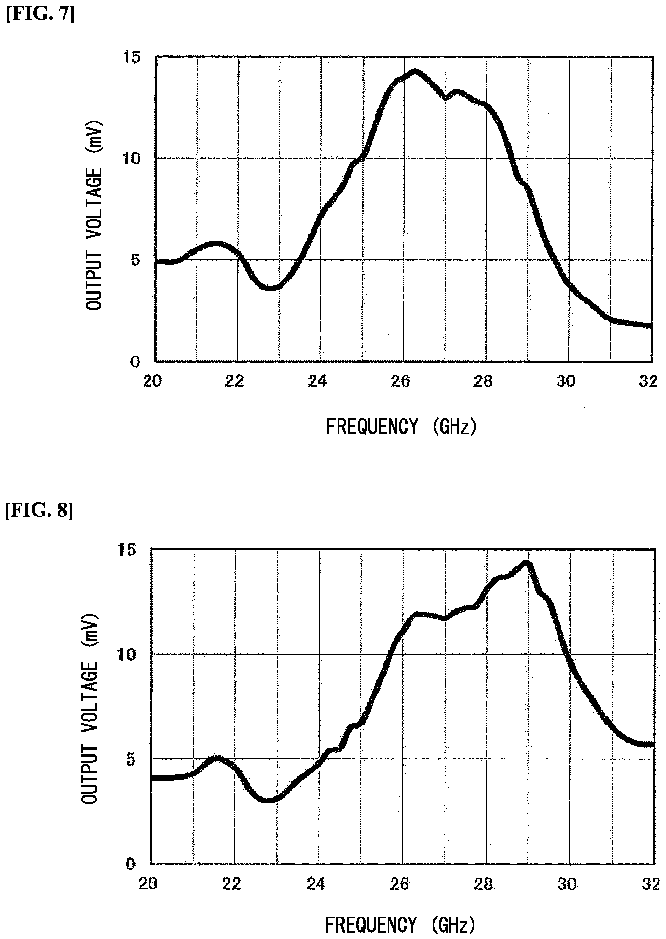

   Figure 7 is an output voltage (mV)-frequency (GHz) characteristic diagram in accordance with an RF detector according to a third embodiment.
[Figure 8]
   Figure 8 is an output voltage (mV)-frequency (GHz) characteristic diagram in accordance with an RF detector according to a fourth embodiment.
[Figure 9]

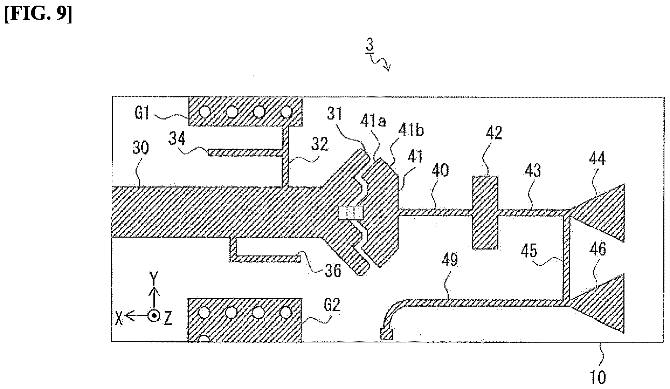

   Figure 9 is a configuration diagram of an RF detector according to a fifth embodiment.
[Figure 10]

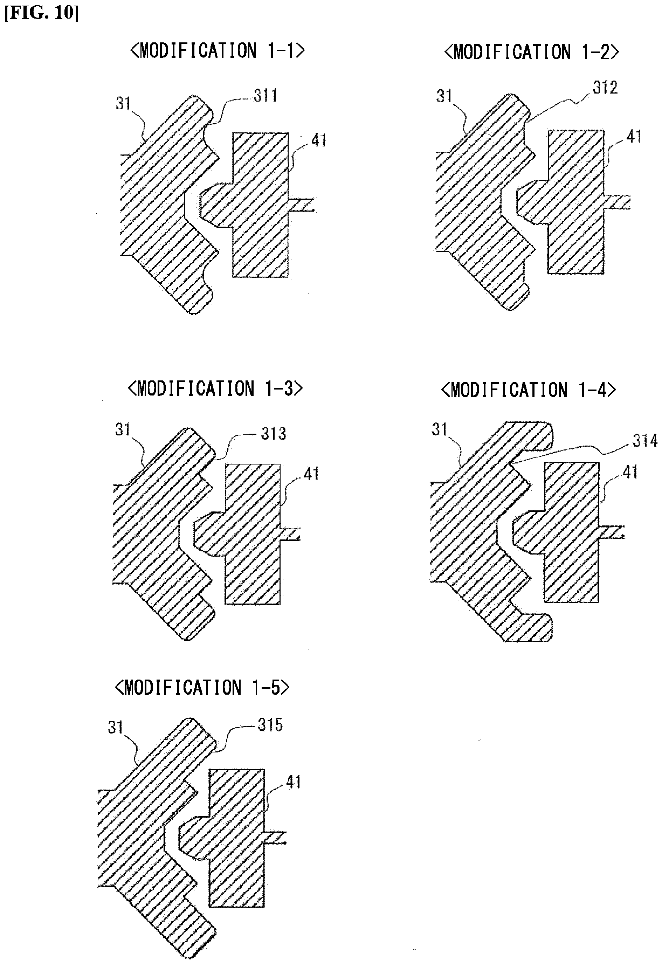

   Figure 10 is an explanatory diagram of Modification 1.
[Figure 11]

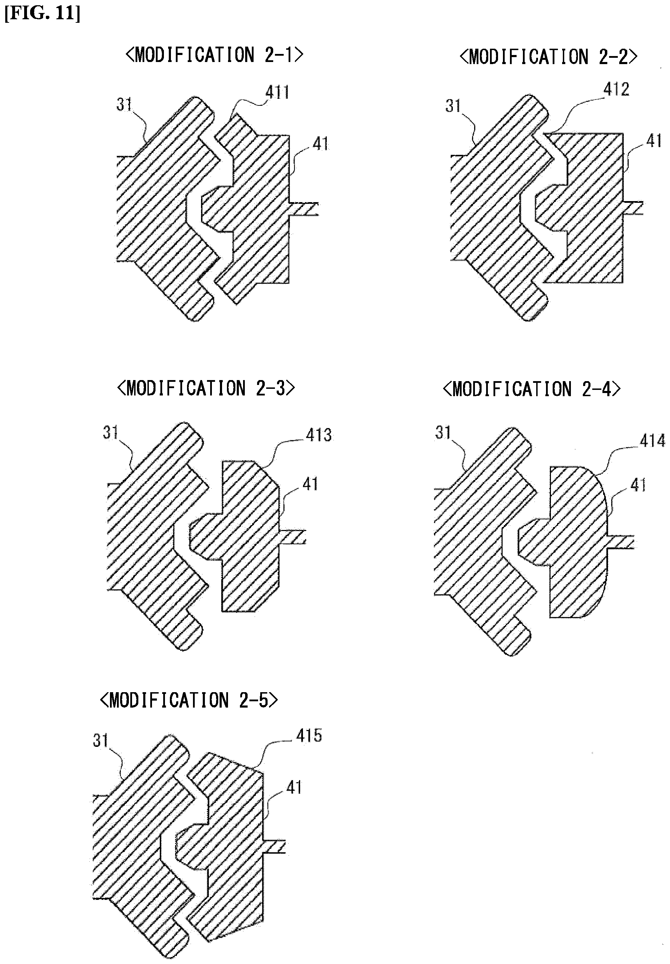

   Figure 11 is an explanatory diagram of Modification 2.
[Figure 12]
   Figure 12 is a diagram illustrating a general configuration example of a high-frequency module.

### Description of Embodiments

### [First Embodiment]

An embodiment example in which the present invention is applied to an RF detector that detects the signal strength of an RF signal in a 28 GHz band (from 26.5 GHz to 29.5 GHz) is described below. Figure 1 is a configuration diagram of an RF detector according to a first embodiment, and Figure 2 is an explanatory diagram of the size and the arrangement interval thereof.

An RF detector 1 of the first embodiment includes a printed circuit board 10, and a detection element 20 that detects an RF signal. As the printed circuit board 10, an FR-4 board (double-sided board) having width size W of 13 mm, depth size D of 8 mm, and thickness T of 0.6 mm is used. On a front surface of the printed circuit board 10, a plurality of conductive patterns patterned in a conductor film having a thickness of about 18 **µ**m are formed. The conductor film is any of copper foil, silver foil, and gold foil and configures a microstrip line. The detection element 20 is a rectifier diode. In the present embodiment, a silicon Schottky barrier diode is used as the detection element 20.

The FR-4 board having the thickness T and the silicon Schottky barrier diode described above are components that are not generally used in a high frequency in a quasi-millimeter-wave band or higher as described above. However, in the present embodiment, the usage becomes easy by contrivance of the shapes and the arrangement of the conductive patterns that are formed in a plurality of numbers. Hereinafter, the above is described below.

In the present description, as a matter of convenience of description, an X-axis, a Y-axis, and a Z-axis that are three orthogonal axes are defined in Figure 1 and Figure 2. In the three orthogonal axes, a +Z direction may be referred to as a vertically upper side of the printed circuit board 10, a -Z direction may be referred to as a vertically lower side of the printed circuit board 10, a +X direction may be referred to as a direction in which the RF signal is input, a -X direction may be referred to as a direction in which the RF signal is output, a +Y direction may be referred to as a left direction when seen from the +X direction, and a -Y direction may be referred to as a right direction when seen from the +X direction. A surface including the X-axis and the Y-axis may be referred to as a front surface, a rear surface, or a horizontal surface of the printed circuit board 10.

In a substantially central portion of the front surface of the printed circuit board 10, an input terminal portion to which an input end (for example, an anode) of the detection element 20 is connected, and an output terminal portion to which an output end (for example, a cathode) of the detection element 20 is connected are formed. When the anode of the detection element 20 is connected to the input terminal portion and the cathode of the detection element 20 is connected to the output terminal portion, the conversion characteristics become a positive output. Contrary to this, when the cathode of the detection element 20 is connected to the input terminal portion and the anode of the detection element 20 is connected to the output terminal portion, the conversion characteristics become a negative output.

In the present embodiment, direct conversion that directly converts the RF signal to voltage is made possible in order to downsize and simplify the structure of the RF detector 1. In the present embodiment, a matching function, a filter function, and a conversion characteristic adjustment function are realized by the plurality of conductive patterns. A part including the input terminal portion out of those plurality of conductive patterns is referred to as a "first conductive pattern". A part including the output terminal portion out of those plurality of conductive patterns is referred to as a "second conductive pattern". The RF detector 1 of the present embodiment also performs a function of cutting off a set frequency on the low-range side by the first conductive pattern. The RF detector 1 of the present embodiment also performs a function of cutting off a set frequency on the high-range side by the second conductive pattern. Those functions are described in detail below.

The first conductive pattern includes an input signal line 30 to which the RF signal is input, a short stub 32 for grounding, and an open stub 34. The input signal line 30 is a stripline in which characteristic impedance is set to 50 **Ω**. Out of the stripline, a line width W₁ of a part to which the RF signal is input is 1.1 mm. The line width W₁ is 7 times or more thicker than the line width of other signal lines described below. Out of the thick input signal line 30, a part in which the abovementioned input terminal portion is formed acts as a matching stub 31 which has a line width that further enlarges as the matching stub 31 approaches the input terminal portion and which becomes an enlarged open end. The reflection of the input RF signal is suppressed in the vicinity of the detection element 20 by a matching effect caused by cooperation of the enlarged open end of the matching stub 31 and a matching stub 41 described below. As a result, the RF signal in the operation frequency as designed is input to the detection element 20.

The matching stub 31 has a symmetrical shape about a line axis (a central axis in the direction orthogonal to the line width, the same applies hereinafter) of the input signal line 30 including the input terminal portion to which an input end of the detection element 20 is connected. An outer edge of the enlarged open end between the end portions is formed in a nonlinear form. In the example in Figure 1 and Figure 2, the outer edge ("coupling region") of the enlarged open end between the end portions is formed to have depressions and protrusions symmetrically about the line axis of the input signal line 30. At least one of protrusion portions forms an acute angle. The acute angle is formed in order to facilitate adjustment operation for the matching and to facilitate capacitive coupling with the matching stub 41 described below.

The short stub 32 is a conductive pattern that has a width of 0.15 mm and attenuates the RF signal propagating through the input signal line 30 at a set frequency in a low range. The short stub 32 is disposed in a section that does not affect matching in the operation frequency band even when grounded. In the drawings, a part that is illustrated in an annular form on a distal end portion of the short stub 32 is a grounding (ground) terminal. A length L₁ of the short stub 32 is set to 1.52 mm that is 1/4 or about 1/4 of the wavelength of the center frequency of the operation frequency band in the present example. The open stub 34 is a conductive pattern that has a width of 0.15 mm and extends from a place near the center of the short stub 32 in a length L₂ (1.49 mm). The open stub 34 is disposed so as to approach and be along the input signal line 30. Under a condition that (L₁/2)<L₂ is satisfied, the length of (L₁/2)+L₂ becomes 1/4 or about 1/4 of the wavelength of the cutoff frequency 24.0 GHz. The open stub 34 configured as above operates as a notch filter. As a result, steep attenuation characteristics can be obtained on the low-range side of the 28 GHz band.

The mounting of an open-stub-type notch filter on the input signal line 30 is a configuration that is often employed. However, when the position and size change due to restriction in the arrangement section when the shape and size of the input signal line 30 are adjusted or another stub and the like are added in the vicinity of the notch filter, for example, a disturbance or a loss in the matching is generated, and a large attenuation cannot be obtained. The short stub 32 is mounted in the present embodiment in consideration of this point. By mounting the short stub 32, the factor that generates the abovementioned disturbance or loss in the matching can be eliminated, a large attenuation can be obtained, and the loss of the RF signal can be suppressed to a minimum.

The second conductive pattern includes the matching stub 41 facing the matching stub 31 of the first conductive pattern across the detection element 20. The matching stub 41 is a conductive pattern that is 0.65 mm (short side)×1.8 mm (long side). The matching stub 41 is mounted in order to realize broadband matching by capacitive reactance generated by distal end coupling of an outer edge ("coupling region") oriented to the matching stub 31. The matching stub 41, which has a long side length of 1/4 or about 1/4 of a set wavelength of the cutoff frequency on the high-range side, and also acts as a stub for reflection in the cutoff frequency on the high-range side.

The second conductive pattern includes a first output signal line 40, a first reflection stub 42, a second output signal line 43, a second reflection stub 44, a third output signal line 45, and an open stub 46 that extend from a central portion of an outer edge ("high-impedance line region") out of the matching stub 41 on the side opposite from the coupling region with the matching stub 31.

Each of the first and second output signal lines 40, 43 is a conductive pattern having a width W₂ of 0.15 mm. Those lines act as high-impedance signal lines for the operation frequency band. The first reflection stub 42 is a conductive pattern that is 0.65 mm (short side)×1.8 mm (long side). The first reflection stub 42, which has a long side length of 1/4 or about 1/4 of the set wavelength of the cutoff frequency on the high-range side. The shape of the first reflection stub 42 does not necessarily need to be the illustrated shape as long as the shape can reflect a cutoff frequency in the high range. The second reflection stub 44 is a triangular conductive pattern which is easier to shape and process than a fan-like pattern, for example. The second reflection stub 44 has a size in which the minimum width is 0.15 mm and the maximum width does not exceed 1.8 mm.

The third output signal line 45 extends from a proximal end (a section having a minimum width) of the second reflection stub 44, and the open stub 46, a capacitor component (C) 47 and a resistance component (R) 48 serving as loads, and a fourth output signal line 49 further extend therefrom. The third output signal line 45 and the fourth output signal line 49 act as high-impedance signal lines for the operation frequency band. Each of the third output signal line 45 and the fourth output signal line 49 is a conductive pattern having a width W₃ of 0.15 mm. The loads are passive elements for stabilizing the operation, and the resistance component (R) 48 and the capacitor component (C) are parallelly connected to a grounding (ground) terminal illustrated in an annular form. In the present example, the resistance component (R) 48 is 510 k**Ω**, and the capacitor component (C) 47 is 100 pF. The open stub 46 is a conductive pattern for matching but can also be omitted.

A length L₃ from the outer edge of the matching stub 41 on the side opposite from the coupling region to a proximal end (a section having a minimum width) of the second reflection stub 44 is 3/4 or about 3/4 of the wavelength of the center frequency of 28 GHz. In the present example, the length L₃ is 4.3 mm. A length L₄ from the outer edge of the matching stub 41 on the side opposite from the coupling region to a facing outer edge of the first reflection stub 42 is 2.5 mm in the present example.

The RF signal that has passed through the matching stub 41 is reflected by the first output signal line 40 and the first reflection stub 42 at a set frequency on the high-range side and is reflected in the operation frequency band by the second output signal line 43 and the second reflection stub 44. The point of reflection (the position at which the reflection occurs) is separated from an output end of the detection element 20. Therefore, phase adjustment can be easily achieved, and cancellation between an input signal of an input end and a reflection signal of an output end in the detection element 20, for example, does not occur. Even when conversion is made again by the detection element 20 and a harmonic component that causes deterioration of the original conversion characteristics is generated, the harmonic component is greatly attenuated by the input signal line width 30 wider than a general input signal line of the related art. Therefore, high conversion characteristics can be obtained.

Figure 3 is a conversion characteristic diagram of the RF detector 1 of the first embodiment. The abscissa axis is the strength (RF_Level: dBm) of the input RF signal, and the ordinate axis is the voltage output (mV). As illustrated, according to the RF detector 1 of the present embodiment, even when the detection element 20 and the printed circuit board 10 that have hitherto only been used in a range from around 1 GHz to around 10 GHz that is a microwave band, sufficient conversion characteristics can be obtained in the 28 GHz band.

Sufficient conversion characteristics can also be obtained in the 28 GHz band because matching is achieved for both the first conductive pattern of the input end of the detection element 20 and the second conductive pattern of the output end of the detection element 20. Therefore, it becomes unnecessary to separately mount a stub for matching on the input signal line 30 as in the related art, the conductive pattern is simplified, and cost reduction and mass production are facilitated.

### [Second Embodiment]

Figure 4 is a configuration diagram of an RF detector 2 according to a second embodiment. The same components and the like as those described in the first embodiment are denoted by the same reference characters, and description thereof is omitted. In the RF detector 2 according to the second embodiment, the open stub 46 of the RF detector 1 is removed, and an open stub 36 having a length L₅ (1.9 mm) of 1/4 or about 1/4 of the wavelength of a notch setting cutoff frequency is added to the side facing the short stub 32 out of the input signal line 30.

The open stub 36 extends downward from the input signal line 30, and then changes the angle and extends in parallel with the input signal line 30. The open stub 36 configured as above acts as a narrow-band notch filter, and the attenuation amount on the lower-range side than the RF detector 1 described in the first embodiment can be caused to be even steeper. The above is made in a narrow band, and hence is hardly affected by mismatching even when there is mismatching.

### [Comparative Example]

The inventor of the present invention has generated an RF detector 5 serving as a comparative example of the RF detectors 1, 2 of the first embodiment and the second embodiment. The RF detector 5 is configured with use of high-frequency components and a design technology frequently used in a quasi-millimeter-wave band at the time of filing of the present application and operates in the 28 GHz band. A configuration diagram of the RF detector 5 is illustrated in Figure 5.

The RF detector 5 is the same as the RF detectors 1, 2 in terms of using an FR-4 board as a printed circuit board 50 and forming a plurality of conductive patterns on the printed circuit board 50 by a microstrip. However, a detection element 60 is a GaAs diode.

An input signal line 70 is connected to an input end of the detection element 60. In the input signal line 70, the signal line width is thinner than that of the input signal line 30 in the first embodiment and the second embodiment, and a part close to an input terminal of the detection element 60 is thin in a tapered form. It has hitherto been a general matching approach to cause a part close to the input terminal out of a thin signal line width to be thin in a tapered form as described above.

The input signal line 70 is grounded by a short stub 71 mounted in a position that is not affected by the operation frequency band. In the illustrated example, a reflection stub 72 is mounted in order to suppress reflection from a grounding end illustrated in an annular form. The reflection stub 72 has a fan shape in a manner in which the distances from a proximal end to outer edges are equal to each other. There is reflection from the input terminal in the detection element 60. Therefore, a stub 74 for matching is needed near a section to which the RF signal is input out of the input signal line 70 in electrical continuity with the input terminal.

A reflection stub 80 set to a length that is 1/4 or about 1/4 of the wavelength of the center frequency of the operation frequency band is disposed in the proximity of an output end of the detection element 60. The reflection stub 80 is shaped in a fan-like shape. An output signal line 81 having a high impedance using a resistance component (R) 87 and a capacitor component (C) 88 as loads is connected to a place near a proximal end of the reflection stub 80, and voltage that becomes a conversion signal is output from an output signal line 89.

An output voltage (mV)-frequency (GHz) characteristic comparison diagram in accordance with the RF detector 2 according to the second embodiment and the RF detector 5 according to the comparative example is illustrated in Figure 6. In Figure 6, a linear broken line 600 is a practical specification reference value, in other words, a value of an output voltage in a practical level. A solid line 601 is the output voltage in accordance with the RF detector 2 of the second embodiment, and a broken line 602 is the output voltage of the RF detector 5 of the comparative example.

As illustrated in Figure 6, in the RF detector 2 of the second embodiment, even when a silicon Schottky diode is used as the detection element 20 and a thick FR-4 board is used as the printed circuit board 10, it can be understood that high output voltage can be obtained as compared to the RF detector 5 using the detection element 60 that is expensive with a design technology of the related art in the FR-4 board. It can also be understood that sufficient output voltage can be obtained across a broad band of about 3 GHz.

In the RF detector 2, steep band characteristics are obtained in a low range and a high range. In a low-range part, steep attenuation is achieved by the notch filter formed by the open stub 36, the short stub 32, and the open stub 34. In a high-range part, reflection and rapid attenuation are achieved by the first reflection stub 42. Therefore, according to the RF detector 2, the conversion characteristics in necessary bands can be remarkably improved as compared to the RF detector 5 according to the comparative example.

The first reflection stub 42 is disposed in a position separated from the output end of the detection element 20, and hence disturbance in matching hardly occurs. The output voltage exceeds the practical specification reference value 600, and hence is in a level that does not have a problem at all in practical use even in an FR-4 board.

### [Effects of Abovementioned Embodiments]

According to the first embodiment and the second embodiment, there can be realized a quasi-millimeter-wave-band RF detector that exhibits high conversion characteristics and filter performance across a board band and corresponds to 5G with low cost even when a silicon Schottky barrier diode and an FR-4 board are used. Since the input signal line 30 can be made thicker, therefore, a thick printed circuit board can be used. Heat generation is also suppressed by causing the input signal line 30 to be thick. The printed circuit board 10 can be caused to be thick, and hence mechanical characteristics (strength and tolerance) increase even without a multi-layer structure.

In a general RF detector of the related art, a reflection signal from an input end of a detection element to an input signal line is generated in every frequency band. Therefore, there are cases where a stub (for example, the stub 74 in Figure 5) and the like are separately mounted in order to prevent the cancellation of the input RF signal by a reflection signal. As a result, however, the conversion characteristics are often sacrificed due to unnecessary reactance loss.

Meanwhile, in the RF detectors 1, 2 of the first embodiment and the second embodiment, the first conductive pattern of the input end of the detection element 20 and the second conductive pattern of the output end of the detection element 20 face each other across the detection element 20. As a result, the reflection signal from the input end of the detection element 20 is absorbed by the inductive reactance of each conductive pattern and the capacitive reactance generated as a result of capacitive coupling between the conductive patterns, and hence the sacrifice of the conversion characteristics is not made.

In particular, the first conductive pattern includes the matching stub 31 which has a line width that is enlarged as the matching stub 31 approaches the input end of the detection element 20 and which forms an enlarged open end, and the outer edge of the enlarged open end between the end portions is formed in a nonlinear form. Therefore, by the thick signal line 30, unnecessary reflection and the like can be suppressed, and matching in a broad band can be achieved. A protrusion that shortens the distance from the facing second conductor pattern is formed on the outer edge of the enlarged open end between the end portions, and hence a structure in which capacitive coupling is easily achieved is obtained.

The respective shapes of the enlarged open end of the matching stub 31, the input end of the detection element 20, the output end of the detection element 20, and the second conductive pattern are symmetrical about the central axis of the input signal line 30. Therefore, the imbalance of the high-frequency current on the printed circuit board 10 is removed, and well-balanced matching can be achieved.

In both of the RF detectors disclosed in Patent Literature 1 and Patent Literature 2, out-of-band attenuation is needed, and hence it is essential to add an RF filter. Regarding the RF filter, attenuation across a broad range is needed, and usage is difficult in a narrow band as for a notch filter. With the RF filter, the cost increases due to size expansion, addition of components, and the like, insertion loss increases, and the conversion characteristics are sacrificed. Meanwhile, the RF detectors 1, 2 of the first embodiment and the second embodiment, the short stub 32 is formed in a predetermined section of the input signal line 30, the open stub 34 extends in a predetermined section of the short stub 32, and the sizes of the short stub 32 and the open stub 34 form a filter in which the cutoff frequency on the low-range side out of the high-frequency signal input to the detection element 20 is caused to be in a lower range than the operation frequency band. Therefore, there is no need to separately mount an RF filter.

A narrow-band notch filter can also be formed when the open stub 36 having a length of about 1/4 of the wavelength of the cutoff frequency on the low-range side is formed in a predetermined section in the direction opposite from the section in which the short stub 32 is formed out of the input signal line 30. Therefore, the low-range part can be caused to be even steeper.

In the first reflection stub 42 and the second reflection stub 44, the outer edge does not necessarily need to be formed in a fan shape to equalize the distances from the proximal end as in the RF detector 5 according to the comparative example, and hence generation, processing, and fine adjustment are easily made. Therefore, designing is also done easily.

### [Third Embodiment]

A third embodiment is described. An RF detector of the third embodiment is obtained by removing the open stub 34, the first reflection stub 42, and the open stub 36 from the RF detector 2 of the second embodiment. Therefore, illustration is omitted. The output voltage (mV)-frequency (GHz) characteristics of the RF detector configured as above is illustrated in Figure 7. With reference to Figure 7, in the RF detector of the third embodiment, as compared to the RF detector 2 of the second embodiment, the effect of broad-range matching is substantially the same, and the output voltage rises and the conversion characteristics are improved on the low-range side, but the conversion characteristics in the high range are slightly sacrificed.

### [Fourth Embodiment]

A fourth embodiment is described. An RF detector of the fourth embodiment is obtained by removing the open stubs 34, 36 from the RF detector 2 of the second embodiment. Therefore, illustration is omitted. The output voltage (mV)-frequency (GHz) characteristics of the RF detector configured as above is illustrated in Figure 8. With reference to Figure 8, in the RF detector of the fourth embodiment, as compared to the RF detector 2 of the second embodiment, the effect of broad-range matching is substantially the same, and the output voltage rises and the conversion characteristics are improved on the high-range side, but the steep characteristics in the low range are slightly sacrificed.

### [Fifth Embodiment]

A fifth embodiment is described. Figure 9 is a configuration diagram of an RF detector 3 according to a fifth embodiment. The same components and the like as those described in the first embodiment and the second embodiment are denoted by the same reference characters, and description thereof is omitted. The RF detector 3 according to the fifth embodiment is different from the RF detector 1 of the first embodiment and the RF detector 2 of the second embodiment in the following points.

- Grounding (ground) terminals G1, G2 have quadrilateral shapes. White circle parts are via holes for electrical continuity with grounding terminals on the opposite surface of the board 10.
- The open stub 34 is caused to face the X direction, in other words, the input side.
- The shape of the matching stub 41 is changed. In other words, out of the matching stub 41, the shape of a coupling region 41a is changed to a shape corresponding to the coupling region on the matching stub 31 side formed to have depressions and protrusions, and a high-impedance line region 41b is changed to a C-chamfered shape.
- The open stub 46 illustrated in Figure 1 has a triangular shape that is substantially the same in shape and area as the second reflection stub 44 and is disposed to be parallel to the second reflection stub 44. The shape of the open stub 46 may be a fan-like shape instead of a triangular shape. In other words, the width of the part to be connected to the third output signal line 45 out of the open stub 46 is caused to gradually decrease so as to approach the width W₃ of the third output signal line 45.

The open stub 34 faces the input side, and hence the coupling with the matching stub 31 is avoided. Therefore, the impedance adjustment between the matching stub 31 and the matching stub 41 becomes easy. The ripple in the operation frequency band is improved.

By changing the coupling region 41a of the matching stub 41 as illustrated, the intervals from the coupling region of the matching stub 31 become substantially equal to each other between the end portions. In other words, not only local coupling (for example, lumped-constant coupling) between a place near the input end on the matching stub 31 side and a place near the output end on the matching stub 41 side to which the detection element 20 is connected, but also planar coupling (for example, distributed-constant coupling) between the coupling region of the matching stub 31 and the coupling region 41a of the matching stub 41 substantially across the entire region is obtained. Therefore, the coupling degree between the matching stubs 31, 41 increases, and the band can be caused to be broader. As a result, options for the detection element 20 that can be used can be increased. The interval between the matching stubs 31, 41 no longer needs to be minute, and it becomes advantageous in terms of manufacturing or processing.

Furthermore, by causing the width of the part to be connected to the third output signal line 45 out of the open stub 46 to gradually decrease so as to approach the width W₃ of the third output signal line 45, planar coupling (for example, distributed-constant coupling) with the third output signal line 45 becomes local coupling (for example, lumped-constant coupling), and hence the impedance adjustment becomes easier.

### [Other Embodiments]

In the first to fifth embodiments, examples in which an FR-4 board is used as the printed circuit board 10 have been described. The printed circuit board 10 is a dielectric body, and hence has a factor called dielectric loss tangent or Dissipation factor (tan **σ**). The dielectric loss tangent expresses the degree to which a part of the electric energy turns into heat and is lost in a dielectric-body part of the printed circuit board when an alternating electric field is applied to the printed circuit board. In other words, when the operation frequency becomes higher, the action of the electric energy changing into heat in the circuit of the printed circuit board becomes greater, and hence transmission loss of the signal becomes greater. The dielectric loss tangent of the FR-4 board is about 0.02 per 1 GHz, but there are some FR-4 boards with small dielectric loss tangent, and it is desired to use those FR-4 boards. However, a glass fluororesin board and the like may be used instead of the FR-4 board for usage in which transmission loss would be critical.

The abovementioned RF detectors 1, 2, 3 can be carried out as one high-frequency module that can be used in a quasi-millimeter-wave band with another high-frequency component, for example, the amplifier 103, the A/D converter 104, the DSP 105, or the antenna ANT illustrated in Figure 12.

### [Modifications]

The combination of the shapes of the matching stub 31 and the matching stub 41 surrounding the detection element 20 can be changed as illustrated in Figure 10 and Figure 11. "Modification 1-1" in Figure 10 is obtained by performing round chamfering (chamfering that rounds off corners) of a coupling region 311 of the open end portion of the matching stub 31 by a small plane (minute chamfering) or a large plane (large chamfering). "Modification 1-2" is obtained by performing C-chamfering (diagonal chamfering) of a coupling region 312 of the open end portion of the matching stub 31 by a small plane or a large plane. "Modification 1-3" is obtained by expanding the width of a coupling region 313 of the open end portion of the matching stub 31. "Modification 1-4" is obtained by extending an outer end portion of a coupling region 314 of the open end portion of the matching stub 31 in the direction of the second conductive pattern. "Modification 1-5" is obtained by extending the outer end portion of a coupling region 315 of the open end portion of the matching stub 31 in diagonal directions.

"Modification 2-1" in Figure 11 is obtained by causing a coupling region 411 of the matching stub 41 to protrude in the direction of a depressed region of the open end portion of the matching stub 31 along the depressed shape of the depressed region. "Modification 2-2" is obtained by causing a coupling region 412 of the matching stub 41 to protrude at an acute angle in the direction of the coupling region of the open end portion of the matching stub 31. "Modification 2-3" is obtained by C-chamfering a high-impedance line region 413 of the matching stub 41. "Modification 2-4" is obtained by semi-cylindrically (in a D-like shape) chamfering a high-impedance line region 414 of the matching stub 41. "Modification 2-5" is obtained by chamfering a high-impedance line region 415 of the matching stub 41 in a trapezoidal shape. The shapes in Figure 10 and Figure 11 are exemplifications and other chamfering shapes may be employed. A combination of the shapes in Figure 10 and Figure 11 may be employed.

In each of the abovementioned embodiments, examples of the RF detectors 1, 2 and the high-frequency module used in the 28 GHz band have been described. However, application can be similarly achieved for an RF detector and a high-frequency module used at a frequency in a 26 GHz band or lower or a 28 GHz band or higher by only changing the sizes of the components.

### [Application Field]

The abovementioned RF detectors 1, 2, 3 are applicable to detection of an RF signal in various fields such as surveillance and watching (security and nursing care), IoT (content distribution and the like), AI (autonomous driving and the like), medical treatment, and healthcare.

According to the present description, the following aspects are provided.

### <First Aspect>

A first aspect is an RF detector including: a detection element configured to detect a signal strength of an RF signal; and a printed circuit board on which a first conductive pattern in electrical continuity with an input end of the detection element and a second conductive pattern in electrical continuity with an output end of the detection element are formed. In the RF detector, the first conductive pattern and the second conductive pattern face each other across the detection element to achieve capacitive coupling between the conductive patterns.

According to the first aspect, the first conductive pattern and the second conductive pattern face each other across the detection element. As a result, the reflection from the input end of the detection element is absorbed by the inductive reactance of each conductive pattern and the capacitive reactance generated as a result of capacitive coupling between the conductive patterns, and hence the sacrifice of the conversion characteristics is not made. The width of the operation frequency band can be enlarged without causing matching between the detection element and each of the first conductive pattern and the second conductive pattern, and hence the detection element and the printed circuit board used in a microwave band can also be used in a band higher than a quasi-millimeter-wave band. Therefore, an RF detector that has sufficient mechanical characteristics and is also capable of reducing cost can be easily realized.

### <Second Aspect>

A second aspect is the RF detector according to the first aspect. In the RF detector, the detection element is a rectifier diode that performs direct conversion of an input RF signal.

According to the second aspect, a quasi-millimeter-wave-band RF detector corresponding to 5G, for example, can be provided with low cost.

### <Third Aspect>

A third aspect is the RF detector according to the first aspect or the second aspect. In the RF detector, the first conductive pattern includes an input signal line which has a line width that is enlarged as the input signal line approaches the input end of the detection element and which forms an enlarged open end, and an outer edge of the enlarged open end between end portions is formed in a nonlinear form.

According to the third aspect, capacitive coupling between the enlarged open end of the first conductive pattern and a part of the second conductive pattern is achieved more easily. By the matching effect by the cooperation of the enlarged open end of the first conductive pattern and a part of the second conductive pattern, reflection in the vicinity of the detection element can be suppressed, matching in a broad band can be achieved, and input to the detection element in the operation frequency as designed is achieved. Therefore, it becomes unnecessary to separately mount a stub for matching on the input signal line as in the related art, the pattern is simplified, and cost reduction and mass production are facilitated.

### <Fourth Aspect>

A fourth aspect is the RF detector according to the third aspect. In the RF detector, a protrusion having a distal end oriented to the second conductive pattern facing the protrusion is formed on the outer edge of the enlarged open end between the end portions.

According to the fourth aspect, adjustment operation for matching is made more easily, and capacitive coupling between the enlarged open end and a part of the second conductive pattern is achieved more easily.

### <Fifth Aspect>

A fifth aspect is the RF detector according to the third aspect or the fourth aspect. In the RF detector, respective shapes of the enlarged open end, the input end of the detection element, the output end of the detection element, and the second conductive pattern are symmetrical about a line axis of the input signal line.

According to the fifth aspect, imbalance of the high-frequency current on the printed circuit board can be removed, and matching can be achieved in a well-balanced manner.

### <Sixth Aspect>

A sixth aspect is the RF detector according to the third aspect 3, the fourth aspect, or the fifth aspect. In the RF detector, a short stub for grounding is formed in a predetermined section of the input signal line, an open stub extends in a predetermined section of the short stub to be parallel to the input signal line, and sizes of the short stub and the open stub form a filter in which a cutoff frequency on a low-range side out of the RF signal input to the detection element is caused to be in a lower range than an operation frequency band.

According to the sixth aspect, the open stub can be operated as a notch filter, and hence steep attenuation characteristics can be obtained on the low-range side. By mounting the short stub, disturbance in the matching does not occur, a large attenuation can be obtained, and moreover the loss can be suppressed to a minimum. Furthermore, an RF filter with which the cost increases due to size expansion, addition of components, and the like, insertion loss increases, and the conversion characteristics are sacrificed does not necessarily need to be separately mounted.

### <Seventh Aspect>

A seventh aspect is the RF detector according to the sixth aspect. In the RF detector, an open stub having a length of about 1/4 of a wavelength of a cutoff frequency on a low-range side is formed in a predetermined section on a side opposite from a section in which the short stub is formed out of the input signal line across the line axis of the input signal line.

According to the seventh aspect, a narrow-band notch filter can be formed, and the low-range side in the conversion characteristics can be caused to be steep. Even when there is mismatching, the effect of the mismatching can be prevented from being easily received due to the narrow band.

### <Eighth Aspect>

An eighth aspect is the RF detector according to any one of the first aspect to the sixth aspect. In the RF detector, the second conductive pattern includes an output signal line that extends from the output end of the detection element, and a reflection stub having a length of about 1/4 of a wavelength of a cutoff frequency on a high-range side is formed in a predetermined section on the output signal line.

According to the eighth aspect, by the reflection stub, the set frequency on the high-range side is reflected, and hence a broad-range part in the conversion characteristics is rapidly attenuated. The point of reflection is separated from an output end of the detection element. Therefore, phase adjustment can be easily made, cancellation between an input signal of an input end and a reflection signal of an output end in the detection element, for example, does not occur, and disturbance in matching does not easily occur.

### <Ninth Aspect>

A ninth aspect is a high-frequency module including an RF detector that exists on a front surface of a printed circuit board with a rear surface serving as a ground conductor, the RF detector detecting a signal level of an input RF signal. In the high-frequency module, the RF detector is the RF detector according to any one of the first aspect to the eighth aspect.

According to the ninth aspect, the width of the operation frequency band can be enlarged without causing matching between the detection element and each of the first conductive pattern and the second conductive pattern, and hence the detection element and the printed circuit board used in a microwave band can also be used in a quasi-millimeter-wave band or higher. Therefore, a high-frequency module that has sufficient mechanical characteristics and is also capable of reducing cost can be easily realized.

## Claims

1. An RF detector, comprising:
a detection element configured to detect a signal strength of an RF signal; and
a printed circuit board on which a first conductive pattern in electrical continuity with an input end of the detection element and a second conductive pattern in electrical continuity with an output end of the detection element are formed,
wherein the first conductive pattern and the second conductive pattern face each other across the detection element to achieve capacitive coupling between the conductive patterns.

2. The RF detector according to claim 1, wherein the detection element is a rectifier diode that performs direct conversion of an input RF signal.

3. The RF detector according to claim 1 or 2, wherein:
the first conductive pattern includes an input signal line which has a line width that is enlarged as the input signal line get closer to the input end of the detection element to form an enlarged open end;
an outer edge of the enlarged open end between end portions is formed in a nonlinear form.

4. The RF detector according to claim 3, wherein a protrusion having a distal end oriented to the second conductive pattern facing the protrusion is formed on the outer edge of the enlarged open end between the end portions.

5. The RF detector according to claim 3 or 4, wherein respective shapes of the enlarged open end, the input end of the detection element, the output end of the detection element, and the second conductive pattern are symmetrical about a line axis of the input signal line.

6. The RF detector according to claims 3 to 5, wherein a short stub for grounding is formed in a predetermined section of the input signal line, an open stub extends in a predetermined section of the short stub to be parallel to the input signal line, and sizes of the short stub and the open stub form a filter in which a cutoff frequency on a low-range side out of the RF signal input to the detection element is caused to be in a lower range than an operation frequency band.

7. The RF detector according to claim 6, wherein an open stub having a length of about 1/4 of a wavelength of a cutoff frequency on a low-range side is formed in a predetermined section on a side opposite from a section in which the short stub is formed out of the input signal line across the line axis of the input signal line.

8. The RF detector according to any one of claims 1 to 6, wherein the second conductive pattern includes an output signal line that extends from the output end of the detection element, and a reflection stub having a length of about 1/4 of a wavelength of a cutoff frequency on a high-range side is formed in a predetermined section on the output signal line.

9. A high-frequency module, comprising an RF detector that exists on a front surface of a printed circuit board with a rear surface serving as a ground conductor, the RF detector detecting a signal level of an input RF signal,
wherein the RF detector is the RF detector according to any one of claims 1 to 8.
